# EUROPEAN PATENT APPLICATION

(11) **EP 4 521 383 A1**
(43) Date of publication of application: **12.03.2025**
(21) Application number: 22963804.4
(22) Date of filing: 01.11.2022
(51) Int. Cl.: G09F 9/30

(54) **ROLLABLE DISPLAY DEVICE**

(71) Applicant: Boe Technology Group Co., Ltd., Beijing 100015 (CN)
(72) Inventor: SHI, Boyang, Beijing 100176 (CN); BIAN, Lupeng, Beijing 100176 (CN); ZHU, Hong, Beijing 100176 (CN); WANG, Bo, Beijing 100176 (CN); CUI, Yue, Beijing 100176 (CN)
(74) Representative: Potter Clarkson
(86) International application number: PCT/CN2022/128882
(87) International publication number: WO 2024/092485

(57) **Abstract**

A rollable display device, comprising a flexible display panel (10). The flexible display panel (10) comprises a fixed area (GD), a rolling area (HJ), and a force application area (SL) which are connected in sequence along a first direction (X); the flexible display panel (10) comprises a support member (1), a spacing layer (2), a back film (3), a display substrate (4), a first adhesive layer (5), and a cover plate (6); the spacing layer (2) is arranged on one side of the support member (1); the back film (3) is arranged on the side of the spacing layer (2) away from the support member (1); the display substrate (4) is arranged on the side of the back film (3) away from the support member (1); the first adhesive layer (5) is arranged on the side of the display substrate (4) away from the support member (1); the cover plate (6) is provided on the side of the first adhesive layer (5) away from the support member (1); the thickness of the cover plate (6) is greater than or equal to 60 microns and less than or equal to 240 microns; and the tensile modulus of the cover plate (6) is greater than or equal to 3 GPa and less than 7 GPa. The rollable display device has good mechanical properties, small rebound force, and good display and touch effects.

## Description

### TECHNICAL FIELD

The present disclosure relates to a field of display technology, and more particularly, to a scrollable display apparatus.

### BACKGROUND

As a first choice of a display apparatus, an Organic Light Emitting Display (OLED) has such advantages as self-luminescence, rapid response, high resolution and high contrast; moreover, a scrollable display apparatus is favored by more and more customers due to its relatively free adjustment of the display surface size.

It should be noted that the information disclosed in the Background section above is only for enhancing the understanding of the background of the present disclosure, and thus may include information that does not constitute prior art known to those of ordinary skill in the art.

### SUMMARY

The present disclosure aims to provide a scrollable display apparatus to overcome shortcomings of the prior art.

According to an aspect of the present disclosure, a scrollable display apparatus, including a flexible display panel, where the flexible display panel includes a fixing region, a scrollable region, and a force application region sequentially connected along a first direction, where the flexible display panel includes:
a support member;
a spacer layer, provided on a side of the support member;
a back film, provided on a side of the spacer layer away from the support member;
a display base substrate, provided on a side of the back film away from the support member;
a first bonding layer, provided on a side of the display base substrate away from the support member; and
a cover plate, provided on a side of the first bonding layer away from the support member, where a thickness of the cover plate is greater than or equal to 60 microns and less than or equal to 240 microns, and a tensile modulus of the cover plate is greater than or equal to 3GPa and less than or equal to 7GPa.

In an exemplary embodiment of the present disclosure, the cover plate is configured as a single-layer structure, the thickness of the cover plate is greater than or equal to 70 microns and less than or equal to 90 microns, and a hardness of a surface of the cover plate away from the support member is greater than a hardness of a surface of the cover plate close to the support member.

In an exemplary embodiment of the present disclosure, the cover plate is configured as a multi-layer structure.

In an exemplary embodiment of the present disclosure, the cover plate includes:
a first layer, provided on the side of the first bonding layer away from the support member, where a thickness of the first layer is greater than or equal to 50 microns and less than or equal to 90 microns;
a second bonding layer, provided on a side of the first layer away from the support member, where a thickness of the second bonding layer is greater than 25 microns and less than or equal to 50 microns, and a storage modulus of the second bonding layer is greater than or equal to 20KPa and less than or equal to 60Kpa; and
a second layer, provided on a side of the second bonding layer away from the support member, where a thickness of the second layer is greater than or equal to 50 microns and less than or equal to 90 microns, a hardness of a surface of the second layer away from the support member is greater than a hardness of a surface of the second layer close to the support member.

In an exemplary embodiment of the present disclosure, a material of the first layer is polyimide, and a Young's modulus of the first layer is greater than or equal to 6GPa and less than or equal to 7Gpa; a material of the second layer is polyimide, and a Young's modulus of the second layer is greater than or equal to 6GPa and less than or equal to 7Gpa; or
a material of the first layer is polyethylene terephthalate, and a Young's modulus of the first layer is greater than or equal to 4GPa and less than or equal to 6Gpa; a material of the second layer is polyethylene terephthalate, and a Young's modulus of the second layer is greater than or equal to 4GPa and less than or equal to 6Gpa.

In an exemplary embodiment of the present disclosure, a storage modulus of the first bonding layer is greater than or equal to the storage modulus of the second bonding layer, and a thickness of the first bonding layer is less than or equal to the thickness of the second bonding layer.

In an exemplary embodiment of the present disclosure, a material of the first bonding layer is an OCA optical adhesive, a thickness of the first bonding layer is greater than or equal to 25 microns and less than or equal to 50 microns, and a storage modulus of the first bonding layer is greater than or equal to 50KPa and less than or equal to 70KPa.

In an exemplary embodiment of the present disclosure, the flexible display panel further includes:
a polarizer, provided between the display base substrate and the first bonding layer, where a thickness of the polarizer is greater than or equal to 60 microns and less than or equal to 70 microns, and a modulus of the polarizer is greater than or equal to 4 GPa and less than or equal to 5Gpa.

In an exemplary embodiment of the present disclosure, a thickness of the back film is greater than or equal to 40 microns and less than or equal to 70 microns, and a Young's modulus of the back film is greater than or equal to 3GPa and less than or equal to 4Gpa.

In an exemplary embodiment of the present disclosure, the spacer layer includes:
a substrate, where a material of the substrate is foam, and a thickness of the substrate is greater than or equal to 50 microns and less than or equal to 100 microns;
a first adhesive layer, bonded between the substrate and the back film, where an adhesion force of the first adhesive layer is greater than or equal to 1000 gf/inch, a storage modulus of the first adhesive layer is greater than or equal to 100 Kpa, and a thickness of the first adhesive layer is greater than or equal to 20 microns and less than or equal to 30 microns; and
a second adhesive layer, bonded between the substrate and the support member, where an adhesion force of the second adhesive layer is greater than or equal to 1000 gf/inch, a storage modulus of the second adhesive layer is greater than or equal to 100 Kpa, and a thickness of the second adhesive layer is greater than or equal to 20 microns and less than or equal to 30 microns.

In an exemplary embodiment of the present disclosure, a material of the spacer layer is an OCA optical adhesive, a thickness of the spacer layer is greater than or equal to 25 microns and less than or equal to 50 microns, a storage modulus of the spacer layer is less than or equal to 40Kpa, and an adhesion force of the spacer layer is greater than or equal to 1000gf/inch.

In an exemplary embodiment of the present disclosure, the display base substrate includes:
a display layer group, provided on the side of the back film away from the support member;
an encapsulation layer group, provided on a side of the display layer group away from the support member;
a touch layer group, provided on a side of the encapsulation layer group away from the support member; and
a polarization layer group, provided on a side of the touch layer group away from the support member, where a storage modulus of the first bonding layer is greater than or equal to 50KPa and less than or equal to 130KPa.

In an exemplary embodiment of the present disclosure, the support member includes:
a first support layer covering the entire spacer layer, where a thickness of the first support layer is greater than or equal to 20 microns and less than or equal to 40 microns, and a Young's modulus of the first support layer is greater than or equal to 90 GPa and less than or equal to 200 Gpa;
a second support layer, provided on a side of the first support layer away from the cover plate; and
a bond layer, bonded between the first support layer and the second support layer.

In an exemplary embodiment of the present disclosure, the support member includes:
a first support layer including a first support plate, a second support plate, and a third support plate sequentially connected, where the first support plate is provided on the fixing region, the second support plate is provided on the scrollable region, the third support plate is provided on the force application region, a plurality of via holes are defined on the second support plate, a modulus of the first support layer in a tensile direction is less than or equal to 4Mpa, a thickness of the first support layer is greater than or equal to 100 microns and less than or equal to 200 microns, and the tensile direction is consistent with the first direction;
a second support layer, provided on a side of the first support layer away from the cover plate; and
a bond layer, bonded between the first support layer and the second support layer.

In an exemplary embodiment of the present disclosure, the bond layer includes:
a base layer, where a thickness of the base layer is greater than or equal to 20 microns and less than or equal to 30 microns;
a first bonding adhesive layer, bonded between the base layer and the first support layer;
a second bonding adhesive layer, bonded between the base layer and the second support layer;
where a thickness of the first bonding adhesive layer is greater than or equal to 15 microns and less than or equal to 30 microns, a storage modulus of the first bonding adhesive layer is greater than 100 KPa, and an adhesion force of the first bonding adhesive layer is greater than or equal to 1000 gf/inch; a thickness of the second bonding adhesive layer is greater than or equal to 15 microns and less than or equal to 30 microns, a storage modulus of the first bonding adhesive layer is greater than 100 KPa, and an adhesion force of the second bonding adhesive layer is greater than or equal to 1000 gf/inch.

In an exemplary embodiment of the present disclosure, the second support layer includes:
a fourth support plate, provided on the fixing region, where a thickness of the fourth support plate is greater than or equal to 200 microns and less than or equal to 500 microns;
a plurality of first support strips, provided on the scrollable region, where a first gap is defined between a first support strip adjacent to the fourth support plate and the fourth support plate, a second gap is defined between two adjacent first support strips, a thickness of the first support strip is greater than or equal to 200 microns and less than or equal to 500 microns, and the first support strip extends along a second direction intersecting with the first direction; and
a connection portion, provided in the first and second gaps, where a modulus of the connection portion is greater than or equal to 1 MPa and less than or equal to 6 MPa.

In an exemplary embodiment of the present disclosure, the second support layer further includes:
a fifth support plate, provided on the force application region, where a thickness of the fifth support plate is greater than or equal to 200 microns and less than or equal to 500 microns.

In an exemplary embodiment of the present disclosure, the bond layer includes:
a bonding portion, bonded between the fourth support plate and the first support layer; and
a plurality of bonding strips, where each bonding strip is correspondingly bonded between the first support strip and the first support layer, an orthographic projection of the first support strip on the back film is located within an orthographic projection of the bonding strip on the back film.

In an exemplary embodiment of the present disclosure, the first support layer is the first support layer according to claim 14, and the orthographic projection of the bonding strip on the back film does not overlap with an orthographic projection of the via hole on the back film.

In an exemplary embodiment of the present disclosure, the support member includes:
a sixth support plate, provided on the fixing region, where a thickness of the sixth support plate is greater than or equal to 200 microns and less than or equal to 500 microns;
a seventh support plate, provided on the force application region, where a thickness of the seventh support plate is greater than or equal to 100 microns and less than or equal to 200 microns;
a plurality of second support strips, provided between the sixth support plate and the seventh support plate, where a thickness of the second support strip is greater than or equal to 200 microns and less than or equal to 500 microns, and the second support strip extends along a second direction intersecting with the first direction; and a plurality of eighth support plates, provided between two adjacent second support strips, between the second support strip and the sixth support plate, and between the second support strip and the seventh support plate, where the eighth support plate is defined with at least one via hole, and a thickness of the eighth support plate is greater than or equal to 100 microns and less than or equal to 200 microns.

It should be understood that the preceding general description and the following detailed description are exemplary and explanatory only and are not restrictive of the present disclosure.

### BRIEF DESCRIPTION OF THE DRAWINGS

The accompanying drawings here are incorporated in the specification and constitute a part of this specification, show embodiments in accordance with the present disclosure and serve to explain the principles of the present disclosure together with the specification. Obviously, the drawings in the following description are turned only some embodiments of the present disclosure, and for those ordinary skills in the art, other drawings may also be obtained from these drawings without creative efforts.
FIG. 1 is a structural schematic diagram of an exemplary embodiment of a scrollable display apparatus according to the present disclosure.
FIG. 2 is a structural schematic diagram of a first exemplary embodiment of a flexible display panel in FIG. 1.
FIG. 3 is a schematic diagram showing a performance comparison between a flexible display panel having a single-layer structural cover plate according to the present disclosure and a flexible display panel with a cover plate having a thickness of less than 60 microns.
FIG. 4 is a structural schematic diagram of a second exemplary embodiment of a flexible display panel in FIG. 1.
FIGS. 5 and 6 are schematic diagrams showing performance comparison among a flexible display panel with a multi-layer structural cover plate according to the present disclosure, a flexible display panel with a relatively thin cover plate and a flexible display panel with a relatively thick cover plate.
FIG. 7 is a schematic diagram showing performance comparison among a flexible display panel according to the present disclosure, a flexible display panel with a relatively great storage modulus of a first bonding layer and a flexible display panel with a relatively low storage modulus of a first bonding layer.
FIG. 8 is a schematic diagram showing performance comparison between a flexible display panel according to the present disclosure and a flexible display panel with a storage modulus of a first bonding layer less than that of a second bonding layer.
FIG. 9 is a schematic diagram showing performance comparison between a flexible display panel according to the present disclosure and a flexible display panel with a polarizer thickness greater than 80 microns.
FIG. 10 is a schematic diagram showing performance comparison between a flexible display panel according to the present disclosure and a flexible display panel with a relatively thin back film.
FIG. 11 is a schematic diagram showing performance comparison between a flexible display panel according to the present disclosure and a flexible display panel with a relatively low storage modulus of a spacer layer.
FIG. 12 is a structural schematic diagram of a third exemplary embodiment of a flexible display panel in FIG. 1.
FIG. 13 is a schematic diagram showing performance comparison between a flexible display panel according to the present disclosure and a flexible display panel with a relatively great modulus in a tensile direction of a first support layer.
FIG. 14 is a structural schematic diagram of a first support plate in FIG. 12.
FIG. 15 is a structural schematic diagram of a second support plate in FIG. 12.
FIG. 16 is a schematic diagram showing performance comparison between a flexible display panel according to the present disclosure and a flexible display panel with a lower storage modulus for both first and second bonding adhesive layers;
FIG. 17 is a structural schematic diagram of a fourth exemplary embodiment of a flexible display panel in FIG. 1.
FIG. 18 is a structural schematic diagram of a fifth exemplary embodiment of a flexible display panel in FIG. 1.
FIG. 19 is a structural schematic diagram of a sixth exemplary embodiment of a flexible display panel in FIG. 1.

Reference numerals
1. support member; 11. first support layer; 111. first support plate; 112. second support plate; 1121. via hole; 113. third support plate; 12. second support layer; 121. fourth support plate; 122. first support strip; 123. connection portion; 124. fifth support plate; 13. bond layer; 131. base layer; 132. first bonding adhesive layer; 133. second bonding adhesive layer; 134. bonding portion; 135. bonding strip;
14. six support plate; 15. seventh support plate; 16. second support strip; 17. eighth support plate;
2. spacer layer; 21. substrate; 22. first adhesive layer; 23. second adhesive layer;
3. back film;
4. display base substrate; TP, touch layer group; TFE, encapsulation layer group;
5. first bonding layer;
6. cover plate; 61. first layer; 62. second bonding layer; 63. second layer;
7. polarizer;
8. rotation shaft; 10. flexible display panel;
GD, fixing region; HJ, scrollable region; SL, force application region;
X. first direction; Y. second direction.

### DETAILED DESCRIPTION

Example embodiments will now be described more fully with reference to the accompanying drawings. However, the embodiments may be implemented in a variety of forms and should not be construed as being limited to the examples set forth herein. Rather, these embodiments are provided such that the present disclosure will be more complete so as to convey the idea of the present exemplary embodiments to those skilled in this art. The same reference numerals in the drawings denote the same or similar parts, and the repeated description thereof will be omitted. In addition, the drawings are merely schematic representations of the present disclosure and are not necessarily drawn to scale.

Although relative terms such as "upper" and "lower" are used in this specification to describe the relative relationship of one component shown to another component, these terms are used in this specification only for convenience of description for example according to the direction of the example described. It may be understood that if a device shown is turned upside down, a component described as being "upper" will become a "lower" component. When a certain structure is "on" another structure, it may mean that the certain structure is integrally formed on said another structure, or that the certain structure is "directly" arranged on said another structure, or that the certain structure is "indirectly" arranged on said another structure through an additional structure.

The terms "a", "an", "the", "said" and "at least one" are used to indicate the presence of one or more elements/components/etc.; the terms "include" and "have" are used to indicate an open type meaning of including and means that there may be additional elements/components/etc. in addition to the listed elements/components/etc.; and the terms "first", "second" and "third" are used as labels only, not a limitation on the number of objects.

A flexible display panel 10 for a scrollable display apparatus includes a fixing region GD, a scrollable region HJ, and a force application region SL sequentially connected along a first direction X; the flexible display panel 10 herein refers to a fully unfolded state, or an unfolded state where the flexible display panel 10 has not yet been mounted on the support frame.

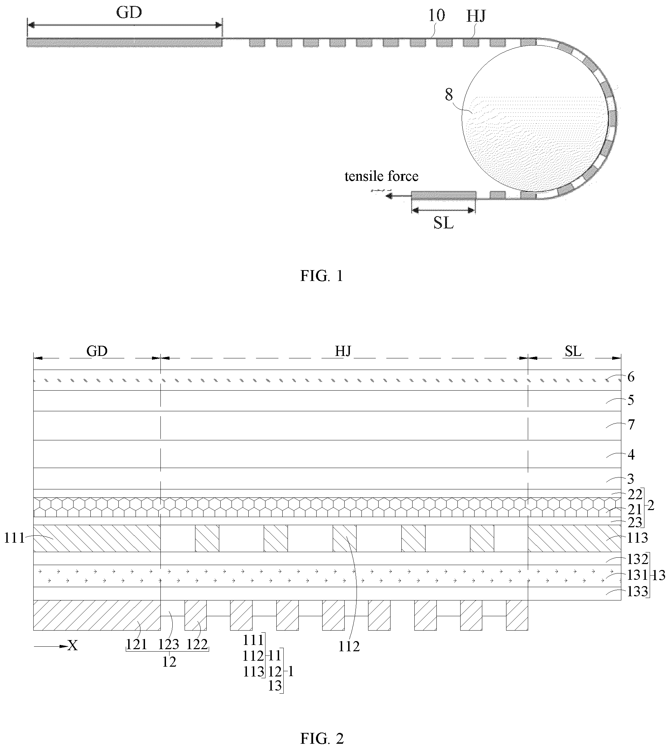

As shown in FIG. 1, the fixing region GD is set to be in a shape of a flat plate, and a part of the fixing region GD is not rolled up, but fixed for display. That is, a minimum display region of the scrollable display apparatus is the part of the fixing region GD. A part of the scrollable region HJ is rolled up on a rotation shaft 8, where the part coplanar with the fixing region GD is displayed and the part not coplanar with the fixing region GD is not displayed. By applying a tensile force to the fixing region GD, the scrollable region HJ is pulled out for display, thereby adjusting a display region of the scrollable display apparatus. The force application region SL is also set to be in a shape of a flat plate and is not rolled up or bent, and the force application region SL is generally not displayed. A tensile force may be applied to a side of the force application region SL away from the scrollable region HJ to ensure that the flexible display panel 10 may be in a flattened state, and the unfolded flexible display panel 10 may also be rolled up.

Due to relatively long length of the scrollable region HJ, the mechanical property of the scrollable region HJ are worse than that of the non- scrollable region. For example, a ball drop height and a pen drop height of the scrollable region HJ are relatively low. The ball drop height refers to a test in which a ball of a specified mass is dropped from different heights to determine an energy required for the flexible display panel 10 to exhibit display and touch control defects under the impact of the ball drop. The pen drop height refers to a test in which a specified pen is dropped from different heights to determine an energy required for the flexible display panel 10 to exhibit display and touch control defects under the impact of the pen drop.

Moreover, due to the impact of the rebound force of the flexible display panel 10, the scrollable region HJ is prone to arching, affecting the flatness of the overall machine; In addition, the rebound force and mechanical property of the flexible display panel 10 are mutually constrained, and generally when the mechanical property is better, the rebound force is larger; while when the rebound force is smaller, the mechanical property is worse.

In addition, the flexible display panel 10 for the scrollable display apparatus is prone to display abnormalities. The inventors discovered that the primary cause of display abnormalities for the flexible display panel 10 for the scrollable display apparatus is prone to display abnormality is that an encapsulation layer group TFE in the display base substrate 4 tends to develop cracks after repeated scrolling, moisture may enter the display layer group (which includes a plurality of switching units and light-emitting units aligned in rows; the switching units control whether the light-emitting units emit light and adjust their brightness) through these cracks, damaging the display layer group and causing display abnormalities. The main reason that the encapsulation layer group TFE is prone to cracking after repeated scrolling is that the encapsulation layer group TFE is not positioned in a neutral layer, which causes it to frequently experience bending stress during the scrolling process, leading to cracking. Furthermore, the flexible display panel 10 for the scrollable display apparatus, when equipped with the touch functionality, is also prone to touch failures or touch abnormalities. The inventors discovered that the primary cause of touch failures or abnormalities is that the touch function layer tends to fracture after repeated scrolling, which prevents the transmission of touch driving signal and touch sensing signal, leading to the touch failures or touch abnormalities. The primary cause for the tendency that the touch function layer fractures after repeated scrolling is that the touch function layer is not positioned in the neutral layer, causing it to frequently experience the bending stress during the scrolling process, resulting in cracks.

During the bending process of the material, an outer layer is stretched and an inner layer is compressed/squeezed, and there is inevitably a transition layer on its cross-section that is neither stretched nor compressed/squeezed, with stress almost equal to zero, and this transition layer is called the neutral layer of the material. A length of the neutral layer during the bending is the same as the length of the neutral layer before the bending, and remains unchanged.

The present disclosure provides a scrollable display apparatus, which may include a flexible display panel 10. The flexible display panel 10 may include a fixing region GD, a scrollable region HJ, and a force application region SL sequentially connected along a first direction X, as shown in FIGS. 2 to 19. The flexible display panel 10 may include a support member 1, a spacer layer 2, a back film 3, a display base substrate 4, a first bonding layer 5, and a cover plate 6; the spacer layer 2 is provided on a side of the support member 1; the back film 3 is provided on a side of the spacer layer 2 away from the support member 1; the display base substrate 4 is provided on a side of the back film 3 away from the support member 1; the first bonding layer 5 is provided on a side of the display base substrate 4 away from the support member 1; and the cover plate 6 is provided on a side of the first bonding layer 5 away from the support member 1. A thickness of the cover plate 6 is greater than or equal to 60 microns and less than or equal to 240 microns, and a tensile modulus of the cover plate 6 is greater than or equal to 3GPa and less than or equal to 7GPa.

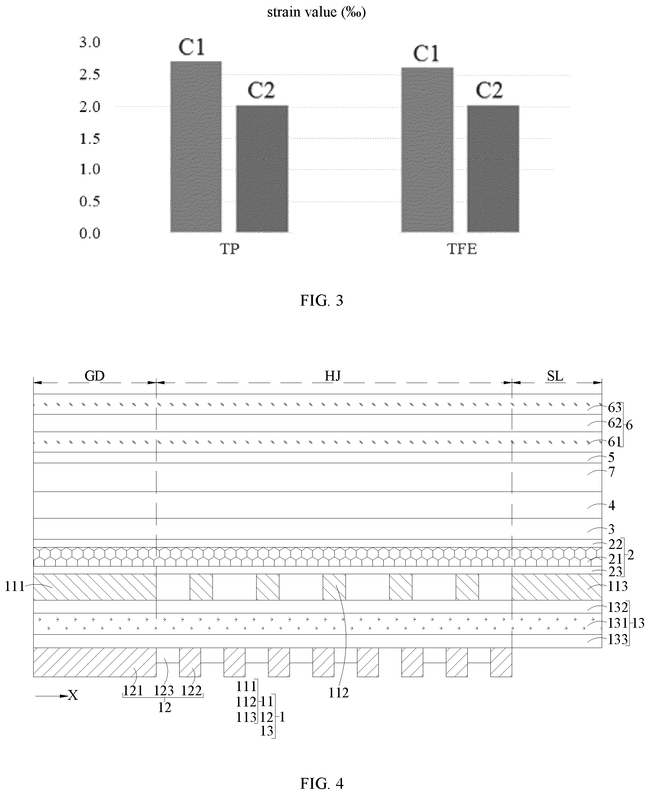

In the flexible display panel 10 of the scrollable display apparatus of the present disclosure, a cover plate 6 is provided on the side of the first bonding layer 5 away from the support member 1, the thickness of the cover plate 6 is greater than or equal to 60 microns and less than or equal to 240 microns, and the tensile modulus of the cover plate 6 is greater than or equal to 3 GPa and less than or equal to 7 GPa. Thus, On one hand, the neutral layer of the flexible display panel 10 is arranged to be close to the encapsulation layer group TFE and touch function layer, as shown in FIG. 3 where a flexible display panel 10 of the present disclosure is labeled as C2, and the comparison flexible display panel 10 is labeled as C1, it may be seen from the figure that a strain value for the encapsulation layer group TFE of the flexible display panel 10 of the present disclosure is approximately 2.0 ‰, and a strain value of the touch layer group TP of the flexible display panel 10 of the present disclosure is approximately 2.0 ‰, whereas a thickness of the cover plate 6 of the comparison flexible display panel 10 is less than 60 microns, a strain value of the encapsulation layer group TFE of the comparison flexible display panel 10 is approximately 2.6 ‰, and a strain value of the touch layer group TP of the comparison flexible display panel 10 is approximately 2.7 ‰. Thus, compared to the comparison flexible display panel 10, the strain value of the touch layer group TP of the flexible display panel 10 in the present disclosure is reduced by approximately 26%, and the strain value of the encapsulation layer group TFE of the flexible display panel 10 in the present disclosure is reduced by approximately 23%, so as to decrease the risk of cracking or fracturing in the touch layer group TP and the encapsulation layer group TFE due to bending stress during the scrolling process, ensuring the display and touch effects of the flexible display panel 10, and ensuring the reliability of the scrolling process.

On the other hand, the flexible display panel 10 of the scrollable display apparatus in the present disclosure has a 25% increase in ball drop height and a 100% increase in pen drop height compared to the comparison flexible display panel 10 (the thickness of the cover plate 6 is less than 60 microns), thereby improving the mechanical property of the flexible display panel 10.

On the other hand, compared to the comparison flexible display panel 10 (the thickness of the cover plate 6 is greater than 240 microns), the flexible display panel 10 of the scrollable display apparatus in the present disclosure shows a 19% reduction in arching in the scrollable region, so as to decrease the rebound force of the flexible display panel 10. Thus, the flexible display panel 10 of the scrollable display apparatus in the present disclosure reduces the rebound force while ensuring the mechanical property.

The cover plate 6 may include a visible region and an ink region set around the visible region, a length of the visible region is greater than a length of the display region of the display base substrate 4, and a width of the visible region is greater than a width of the display region of the display base substrate 4.

In order to prevent the adhesive overflow during the bonding process, the first bonding layer 5 may be retracted by 0.1 mm to 0.2 mm in a length direction relative to the cover plate 6, the display base substrate 4 or the polarizer 7, and that is, the first bonding layer 5 is 0.2 mm to 0.4 mm shorter in the length direction than the cover plate 6, the display base substrate 4 or the polarizer 7; the first bonding layer 5 may be retracted by 0.1 mm to 0.2 mm in a width direction relative to the cover plate 6, the display base substrate 4, or the polarizer 7, and that is, the first bonding layer 5 is 0.2 mm to 0.4 mm shorter in the width direction than the cover plate 6, the display base substrate 4, or the polarizer 7.

It should be noted that the length direction is the first direction X, and the width direction is the second direction Y.

The polarizer 7, the display base substrate 4, and the back film 3 may be cut to the same size after lamination using an integrated cutting manner.

Of course, the cover plate 6, the first bonding layer 5, the polarizer 7, the display base substrate 4, and the back film 3 may be laminated and then cut to the same size using an integrated cutting manner.

In an exemplary embodiment of the present disclosure, the cover plate 6 may be configured as a single-layer structure, and a material of the cover plate 6 may be polyimide (PI) or polyethylene terephthalate (PET). An outer surface of the cover plate 6 is hardened to ensure that a hardness of a surface of the cover plate 6 away from the support member 1 is greater than a hardness of a surface of the cover plate 6 close to the support member 1. A thickness of the cover plate 6 is greater than or equal to 60 microns and less than or equal to 90 microns. For example, the thickness of the cover plate 6 may be 71 microns, 75 microns, 76.5 microns, 79 microns, 81.3 microns, 84.5 microns, 85.7 microns, 86.3 microns, 87.5 microns, 88.7 microns, etc; a Young's modulus of the cover plate 6 is greater than or equal to 4 GPa and less than or equal to 7Gpa. For example, the Young's modulus of the cover plate 6 may be 4.3Gpa, 4.8Gpa, 4.94Gpa, 5.2Gpa, 5.64Gpa, 5.8Gpa, 5.98Gpa, 6.2Gpa, 6.84Gpa, etc.

It should be noted that in the case of a single-layer structural cover plate 6, the Young's modulus is the tensile modulus.

As shown in FIG. 3, a flexible display panel 10 of the present disclosure is labeled as C2 in the figure, while the comparison flexible display panel 10 is labeled as C1 it may be seen from the figure that a strain value for the encapsulation layer group TFE of the flexible display panel 10 of the present disclosure is approximately 2.0 ‰, and a strain value of the touch layer group TP of the flexible display panel 10 of the present disclosure is approximately 2.0 ‰. However, a thickness of the cover plate 6 of the comparison flexible display panel 10 is less than 60 microns, a strain value of the encapsulation layer group TFE of the comparison flexible display panel 10 is approximately 2.6 ‰, and a strain value of the touch layer group TP of the comparison flexible display panel 10 is approximately 2.7 ‰. Thus, compared to the comparison flexible display panel 10, the strain value of the touch layer group TP of the flexible display panel 10 in the present disclosure is reduced by approximately 26%, and the strain value of the encapsulation layer group TFE of the flexible display panel 10 in the present disclosure is reduced by approximately 23%, so as to decrease the risk of cracking or fracturing in the touch layer group TP and the encapsulation layer group TFE due to bending stress during the scrolling process, ensuring the display and touch effects of the flexible display panel 10, and ensuring the reliability of the scrolling process.

On the other hand, the flexible display panel 10 of the present disclosure has a 25% increase in ball drop height and a 100% increase in pen drop height compared to the comparison flexible display panel 10 (the thickness of the cover plate 6 is less than 60 microns), thereby improving the mechanical property of the flexible display panel 10.

On the other hand, compared to the comparison flexible display panel 10 (the thickness of the cover plate 6 is greater than 240 microns), the flexible display panel 10 of the present disclosure shows a 21% reduction in arching in the scrollable region, so as to decrease the rebound force of the flexible display panel 10. Thus, the flexible display panel 10 of the scrollable display apparatus in the present disclosure reduces the rebound force while ensuring the mechanical property.

In another exemplary embodiment of the present disclosure, as shown in FIG. 4, the cover plate 6 may be configured as a multi-layer structure. Specifically, the cover plate 6 may include a first layer 61, a second bonding layer 62, and a second layer 63. The first layer 61 is provided on the side of the first bonding layer 5 away from the support member 1. A thickness of the first layer 61 is greater than or equal to 50 microns and less than or equal to 90 microns. For example, the thickness of the first layer 61 may be 51 microns, 55 microns, 66.5 microns, 69 microns, 71.3 microns, 74.5 microns, 75.7 microns, 86.3 microns, 87.5 microns, 88.7 microns, etc; a material of the first layer 61 may be polyimide, and a Young's modulus of the first layer 61 is greater than or equal to 6 GPa and less than or equal to 7Gpa. For example, the Young's modulus of the first layer 61 may be 6.1Gpa, 6.2Gpa, 6.64Gpa, 6.84Gpa, 6.98Gpa, etc.

The second bonding layer 62 is provided on a side of the first layer 61 away from the support member 1, a material of the second bonding layer 62 is an OCA optical adhesive, and a thickness of the second bonding layer 62 is greater than 25 microns and less than or equal to 50 microns. For example, the thickness of the second bonding layer 62 may be 26 microns, 31 microns, 36.5 microns, 39 microns, 41.3 microns, 44.5 microns, 45.7 microns, 46.3 microns, 47.5 microns, 48.7 microns, etc; a storage modulus of the second bonding layer 62 is greater than or equal to 20 KPa and less than or equal to 60 Kpa. For example, the storage modulus of the second bonding layer 62 may be 22 KPa, 25.2 KPa, 34 KPa, 36.64 KPa, 38.6 KPa, 43 KPa, 46.84 KPa, 51 KPa, 56.98 KPa, etc.

The second layer 63 is provided on a side of the second bonding layer 62 away from the support member 1, a surface of the second layer 63 away from the support member 1 serves as a display surface of the entire display panel 10, the surface of the second layer 63 away from the support member 1 is hardened such that the hardness of the surface of the second layer 63 away from the support member 1 is greater than the hardness of the surface of the second layer 63 close to the support member 1. A thickness of the second layer 63 is greater than or equal to 50 microns and less than or equal to 90 microns. For example, the thickness of the second layer 63 may be 51 microns, 55 microns, 66.5 microns, 69 microns, 71.3 microns, 74.5 microns, 75.7 microns, 86.3 microns, 87.5 microns, 88.7 microns, etc. A material of the second layer 63 may be polyimide (PI), and a Young's modulus of the second layer 63 may be greater than or equal to 6 GPa and less than or equal to 7Gpa. For example, the Young's modulus of the second layer 63 may be 6.1Gpa, 6.2Gpa, 6.64Gpa, 6.84Gpa, 6.98Gpa, etc.

Of course, in some other exemplary embodiments in the present disclosure, a material of the first layer 61 may be polyethylene terephthalate (PET), and a Young's modulus of the first layer 61 may be greater than or equal to 4 GPa and less than or equal to 6Gpa. For example, the Young's modulus of the first layer 61 may be 4. 1Gpa, 4.2Gpa, 4.8Gpa, 5.1Gpa, 5.64Gpa, 5.84Gpa, 5.98Gpa, etc; the material of the second layer 63 may be polyethylene terephthalate, a Young's modulus of the second layer 63 is greater than or equal to 4 GPa and less than or equal to 6Gpa. For example, the Young's modulus of the second layer 63 may be 4.1Gpa, 4.2Gpa, 4.8Gpa, 5.1Gpa, 5.64Gpa, 5.84Gpa, 5.98Gpa, etc.

The cost of polyethylene terephthalate is lower than that of polyimide, but high-modulus polyethylene terephthalate tends to crease visibly, so a lower Young's modulus polyethylene terephthalate is preferably selected when using the polyethylene terephthalate.

It should be noted that in the case of a multi-layer structural cover plate 6, the Young's modulus of each layer mentioned above may be equivalent to the tensile modulus of the multi-layer structural cover plate, and the tensile modulus of the multi-layer structural cover plate 6 is greater than or equal to 3 GPa and less than or equal to 6Gpa. For example, the Young's modulus of the cover plate 6 may be 3.3Gpa, 3.8Gpa, 3.94Gpa, 4.2Gpa, 4.64Gpa, 4.8Gpa, 4.98Gpa, 5.2Gpa, 5.6Gpa, 5.84Gpa, etc.

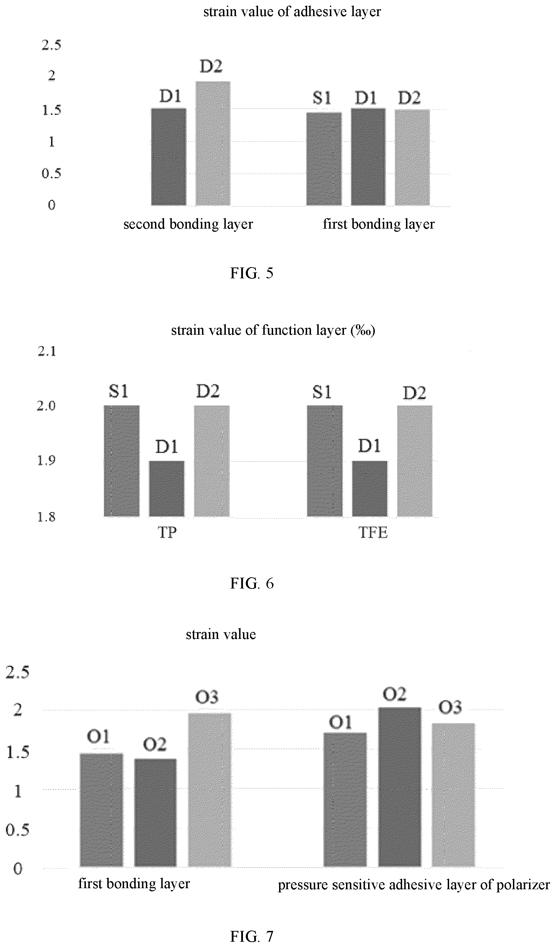

As shown in FIGS. 5 and 6, D1 in the figure represents a flexible display panel 10 where the thickness of the first layer 61 and the second layer 63 of the cover plate 6 is relatively thick. Specifically, the thickness of the first layer 61 is greater than or equal to 80 microns and less than or equal to 90 microns, and the thickness of the second layer 63 is also greater than or equal to 80 microns and less than or equal to 90 microns; a storage modulus of the second bonding layer 62 is relatively high, for example, the storage modulus of the second bonding layer 62 is greater than or equal to 50 KPa and less than or equal to 60 Kpa. Compared with the single-layer structural cover plate 6 in FIG. 2, the pen drop height may be increased by approximately 200%, and the ball drop height may be increased by approximately 100%, but the module rebound force is increased by 53%, which requires higher performance requirements for device thrust.

D2 represents that a flexible display panel 10 where the thickness of the first layer 61 and the second layer 63 of the cover plate 6 is relatively thin. Specifically, the thickness of the first layer 61 is greater than or equal to 50 microns and less than or equal to 60 microns, and the thickness of the second layer 63 is also greater than or equal to 50 microns and less than or equal to 60 microns; the storage modulus of the second bonding layer 62 is relatively low, for example, the storage modulus of the second bonding layer 62 is greater than or equal to 20 KPa and less than or equal to 50 Kpa. Compared with the single-layer structural cover plate 6 in FIG. 2, the mechanical properties and the rebound forces are similar, and the ball drop height may be increased by approximately 20%.

The display panel 10 with the single-layer structural cover plate 6 in FIG. 2 is labeled as S1 in FIGS. 5 and 6, as shown in FIG. 6. The strain values of the function layers in the figure include a strain value of the touch layer group TP and a strain value of the encapsulation layer group TFE. Comparing the relatively thick D1 and the relatively thin D2 with the single-layer structure S1, there is no significant change in the strain values of the touch panel group TP and the encapsulation layer group TFE, which are approximately 2.0; only the relatively thick D1 has relatively low strain values for the touch layer group TP and the encapsulation layer group TFE, which are approximately 1.9; as shown in FIG. 5, the strain values of the adhesive layers in the figure include the strain value of the first bonding layer 5 and the strain value of the second bonding layer 62. Comparing the relatively thick D1 and the relatively thin D2 with the single-layer structure S1, the strain values of the first bonding layers 5 in the adhesive layer strains are similar, which are approximately 1.5; however, the strain value of the second bonding layer 62 in the D2 structure is relatively high, approximately 1.9, but remains within the safe range.

Moreover, both the single-layer structural cover plate 6 and the double-layer structural cover plate 6 within the above range may pass the reliability testing.

A material of the first bonding layer 5 may be an OCA optical adhesive, and a thickness of the first bonding layer 5 is greater than or equal to 25 microns and less than or equal to 50 microns. For example, a thickness of the first bonding layer 5 may be 26 microns, 29 microns, 31 microns, 36.5 microns, 39 microns, 41.3 microns, 44.5 microns, 45.7 microns, 46.3 microns, 48.5 microns, 49.7 microns, etc; a storage modulus of the first bonding layer 5 is greater than or equal to 50 KPa and less than or equal to 70 KPa. For example, the storage modulus of the first bonding layer 5 may be 51 KPa, 56.98 KPa, 57.2 KPa, 59 KPa, 63 KPa, 64 KPa, 66.64 KPa, 68.6 KPa, etc.

As shown in FIG. 7, O1 in the figure represents the flexible display panel 10 using the first bonding layer 5 according to the above embodiment, O2 represents the display panel 10 using the first bonding layer 5 with a storage modulus greater than 80KPa, O3 represents the display panel 10 using the first bonding layer 5 with a storage modulus less than 40KPa. From the figure, it may be seen that the strain value of the first bonding layer 5 of O3 display panel 10 is approximately 1.9, and the strain value of the first bonding layer 5 of O1 display panel 10 is approximately 1.4. Thus, the strain value of the first bonding layer 5 of O3 display panel 10 is 36% higher than that of O1 display panel 10, indicating a risk of adhesive layer failure in the first bonding layer 5 of O3 display panel 10.

From the figure, it may also be seen that the strain value of the pressure sensitive adhesive layer on the polarizer 7 of the O2 display panel 10 is approximately 2, and the strain value of the pressure sensitive adhesive layer on the polarizer 7 of the O1 display panel 10 is approximately 1.7. Compared with the O1 display panel 10, the strain value of the pressure sensitive adhesive layer on the polarizer 7 of the O2 display panel 10 increases by 18%. Thus, by adopting the first bonding layer 5 in the present exemplary embodiment, both the strain value of the first bonding layer 5 and the strain value of the pressure sensitive adhesive layer of the polarizer 7 are more optimal.

In the case where the cover plate 6 is configured as the multi-layer structure, the storage modulus of the first bonding layer 5 is greater than or equal to the storage modulus of the second bonding layer 62, and the thickness of the first bonding layer 5 is less than or equal to the thickness of the second bonding layer 62.

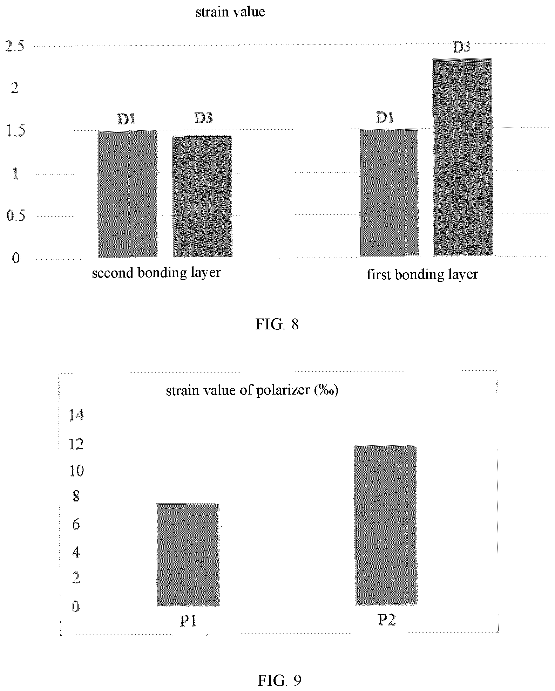

Referring to FIG. 8, D1 in the figure represents the display panel 10 using the first bonding layer 5 and the second bonding layer 62 that meet the above requirements (the display panel shown in FIG. 4 and also meeting the requirements of D1 display panel in FIGS. 5 and 6); D3 represents a display panel 10 using a second bonding layer 62 with a storage modulus greater than 50 Kpa and a first bonding layer 5 with a storage modulus less than 50 KPa. From the figure, it may be seen that the strain values of the second bonding layers 62 in the two display panels 10 are not significantly different, being around 1.4. However, the strain value of the first bonding layer 5 in the D3 display panel 10 sharply increases to approximately 2.3, exceeding the safe strain value range of the first bonding layer 5, and the safe strain value range of the first bonding layer 5 is approximately 2.

As shown in FIGS. 2 and 4, the display panel 10 may also include a polarizer 7, which is provided between the display base substrate 4 and the first bonding layer 5. A thickness of the polarizer 7 may be greater than or equal to 60 microns and less than or equal to 70 microns, for example, the thickness of the polarizer 7 may be 61 microns, 65 microns, 66.5 microns, 69 microns, etc; a modulus of the polarizer 7 may be greater than or equal to 4 GPa and less than or equal to 5Gpa. For example, the modulus of the polarizer 7 may be 4.3Gpa, 4.8Gpa, 4.94Gpa, 5.2Gpa, 5.64Gpa, 5.8Gpa, 5.98Gpa, etc. The polarizer 7 may include a linear polarization layer, a phase difference layer, a TAC (Triacetyl Cellulose) film, a COP (optical material) film, and a pressure sensitive adhesive (PSA) sequentially stacked, and the pressure sensitive adhesive is bonded with the display base substrate 4. The COP film is bonded to the display base substrate 4 through the pressure sensitive adhesive, the linear polarization layer is bonded to the first layer 61 through the first bonding layer 5, or the linear polarization layer is bonded to the second layer 63 through the second bonding layer 62.

The TAC film is one of the polymer materials with the highest transmittance.

As shown in FIG. 9, P2 in the figure represents a flexible display panel 10 using a polarizer 7 with a thickness greater than 80 microns, and P1 represents a flexible display panel 10 including the polarizer 7 in the present exemplary embodiment. From the figure, it may be seen that the stress value of the polarizer 7 in the present embodiment is approximately 7.8 ‰, and the stress value of the polarizer 7 in the display panel 10 using a relatively thick polarizer 7 is approximately 11.9 ‰; which leads to a significant rise in the strain along the tensile direction of the polarizer 7 and a significant rise in the strain value of the pressure sensitive adhesive layer of the polarizer 7, with cracking observed in actual tests.

Moreover, using a thinner polarizer 7 (for example, with a thickness less than 50 microns) shifts the neutral layer of the display base substrate 4 downward, increasing the strain values of the touch layer group TP and the encapsulation layer group TFE, resulting in the touch failure and the encapsulation layer group TFE cracking. Thus, the polarizer 7 in the present exemplary embodiment provides optimal effect in various aspects.

Of course, in some other exemplary embodiments in the present disclosure, a polarization layer group may be integrated in the display base substrate 4 instead of the polarizer 7, offering the same functionality as the polarizer 7. In this case, the first bonding layer 5 should use a higher modulus adhesive material, such that the neutral layer of the display panel 10 is close to the touch layer group TP and the encapsulation layer group TFE, to reduce the strain values of the touch layer group TP and the encapsulation layer group TFE. Specifically, the storage modulus of the first bonding layer 5 is greater than or equal to 50 KPa and less than or equal to 130 Kpa. For example, the storage modulus of the first bonding layer 5 may be 51 KPa, 56.98 KPa, 57.2 KPa, 59 KPa, 63 KPa, 64 KPa, 66.64 KPa 68.6 Kpa, 71 KPa, 76.8 KPa, 77.2 KPa, 79 KPa, 83 KPa, 84 KPa, 96.64 KPa, 98.6 Kpa, 101 KPa, 106.9 KPa, 107.2 KPa, 119 KPa, 123 KPa, 124 KPa, etc.

The display base substrate 4 may also include a display layer group, an encapsulation layer group TFE, and a touch layer group TP; The display layer is provided on the side of the back film 3 away from the support member 1; the display layer group may include a plurality of switching units and light-emitting units aligned in rows, the switching units control whether the light-emitting units emit light and their brightness. The encapsulation layer group TFE is provided on a side of the display layer group away from the support member 1; the encapsulation layer group TFE may be configured as multiple layers, and the encapsulation layer group TFE may include an organic layer and an inorganic layer. Specifically, the encapsulation layer group TFE may include a first inorganic layer, an organic layer provided on a side of the first inorganic layer away from the base substrate, and a second inorganic layer provided on a side of the organic layer away from the base substrate. Materials of the first inorganic layer, the organic layer, and the second inorganic layer are not elaborated here. Of course, the encapsulation layer group TFE may also include more or fewer layers.

The touch layer group TP is provided on the side of the encapsulation layer group TFE away from the support member 1; the touch layer group TP may include a first touch metal layer, a touch insulation layer, a second touch metal layer, and a protective layer. The first touch metal layer is provided on a side of the encapsulation layer group TFE away from the base substrate, the touch insulation layer is provided on the a of the first touch metal layer away from the base substrate, and the second touch metal layer is provided on a side of the touch insulation layer away from the base substrate, the protective layer is provided on a side of the second touch metal layer away from the base substrate. The first touch metal layer and the second touch metal layer form a grid-shaped conductive portion, which is formed by interweaving a plurality of metal wires, and that is, the grid-shaped conductive portion includes a plurality of grids, and the grid is a polygon composed of a plurality of grid lines. One grid corresponds to one sub-pixel, and an orthographic projection of the sub-pixel on the base substrate is located within an orthographic projection of the grid on the base substrate, preventing grid lines from blocking light emitted by the sub-pixels and ensuring the display effect of display panel 10.

The polarization layer group is provided on a side of the touch layer group TP away from the support member 1.

The touch layer group TP may also be designed as an external type, that is, after the touch layer group TP is prepared separately, the touch layer group TP is bonded to a side of the encapsulation layer group TFE away from the support member 1.

The thickness of the back film 3 is greater than or equal to 40 microns and less than or equal to 70 microns. For example, the thickness of the back film 3 may be 41 microns, 41.3 microns, 44.5 microns, 45.7 microns, 46 microns, 46.3 microns, 48.5 microns, 49 microns, 49.7 microns, 56.5 microns, 59 microns, etc; a Young's modulus of the back film 3 is greater than or equal to 3 GPa and less than or equal to 4Gpa. For example, the Young's modulus of back film 3 may be 3.2Gpa, 3.3Gpa, 3.64Gpa, 3.8Gpa, 3.84Gpa, 3.94Gpa, 3.98Gpa, etc. A material of back film 3 may be polyimide (PI) or polyethylene terephthalate (PET).

According to simulation and test results, the back film 3 may provide sufficient support, ensuring a binding process yield, and reducing the strain value of the function layer at the junction of the fixing region GD and the scrollable region HJ.

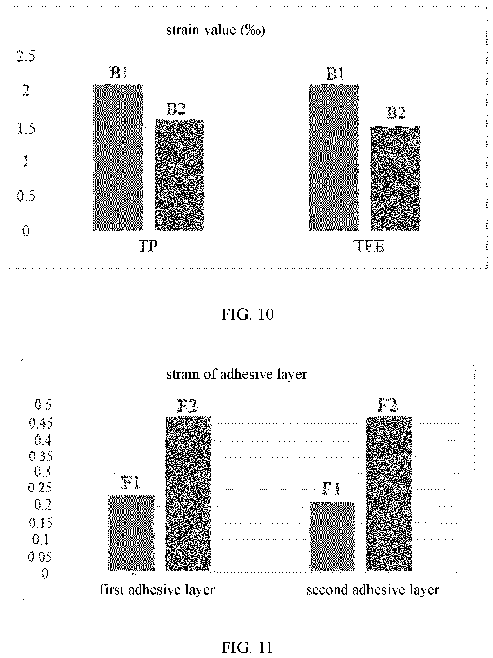

Specifically, as shown in FIG. 10, B1 represents a flexible display panel 10 designed with a relatively thin back film 3 (thickness<30 um), and B2 represents a flexible display panel 10 with the back film 3 in the present example embodiment. From the figure, it may be seen that the strain value of the touch layer group TP at the junction of the fixing region GD and the scrollable region HJ of B2, the flexible display panel 10 of the back film 3 in the present exemplary embodiment, is approximately 1.6 ‰, and the strain value of the encapsulation layer group TFE of B2 is approximately 1.5 ‰. The strain value of the touch layer group TP of B1, the flexible display panel 10 with a relatively thin back film 3, is approximately 2.1 ‰, and the strain value of the encapsulation layer group TFE of B1 at the junction of the fixing region GD and the scrollable region HJ is approximately 2.1 ‰. Thus, compared to the strain values of the touch layer group TP of B2, the flexible display panel 10 using a back film 3 in the present embodiment, the strain values of the touch layer group TP and the encapsulation layer group TFE of B1, the display panel 10 using a relatively thin back film 3, are increased by approximately 31%, and compared to the strain value of the encapsulation layer group TFE of the flexible display panel 10 using the back film 3 in the present exemplary embodiment, the strain value of the encapsulation layer group TFE of the display panel 10 using a relatively thin back film 3 is increased by approximately 40%. Therefore, the display panel 10 using a relatively thin back film 3 raises the risk of failure for both the encapsulation layer group TFE and the touch layer group TP, whereas the encapsulation layer group and the touch layer group TP of the display panel 10 using the back film 3 in the present exemplary embodiment has a relatively low failure risk.

In addition, if high modulus polyimide (PI) or polyethylene terephthalate (PET) is used for the back film 3, it may shift the neutral layer of the display panel 10 downward, thereby increasing the strain values of the touch layer group TP and the encapsulation layer group TFE, which raises the risk of failure.

In the present exemplary embodiment, the spacer layer 2 may include a substrate 21, a first adhesive layer 22, and a second adhesive layer 23; a material of the substrate 21 may be foam, and a thickness of the substrate 21 is greater than or equal to 50 microns and less than or equal to 100 microns. For example, the thickness of the substrate 21 may be 51 microns, 55 microns, 56.5 microns, 59 microns, 61.3 microns, 64.5 microns, 65.7 microns, 66.3 microns, 67.5 microns, 68.7 microns, 71 microns, 73 microns, 76.5 microns, 79 microns, 81.3 microns, 84.5 microns, 85.7 microns, 91 microns, 93 microns, 96.5 microns, etc.

The first adhesive layer 22 is bonded between the substrate 21 and the back film, an adhesion force of the first adhesive layer 22 is greater than or equal to 1000 gf/inch, a storage modulus of the first adhesive layer 22 is greater than or equal to 100 Kpa, and a thickness of the first adhesive layer 22 is greater than or equal to 20 microns and less than or equal to 30 microns. For example, the thickness of the first adhesive layer 22 may be 21 microns, 25 microns, 26.5 microns, 29 microns, etc.

The second adhesive layer 23 is bonded between the substrate 21 and the support member 1, an adhesion force of the second adhesive layer 23 is greater than or equal to 1000gf/inch, a storage modulus of the second adhesive layer 23 is greater than or equal to 100Kpa, and a thickness of the second adhesive layer 23 is greater than or equal to 20 microns and less than or equal to 30 microns. For example, the thickness of the second adhesive layer 23 may be 21 microns, 25 microns, 26.5 microns, 29 microns, etc.

The materials of the first adhesive layer 22 and the second adhesive layer 23 may both pressure sensitive adhesive.

The storage modulus is essentially the Young's modulus, which is an indicator of the material's rebound after deformation, which represents a material's ability to store elastic deformation energy and also represents the energy stored by viscoelastic materials due to elastic deformation during the deformation process.

As shown in FIG. 11, F1 represents a flexible display panel 10 using the spacer layer 2 in the present embodiment, F2 represents a flexible display panel 10 using the spacer layer 2 with a storage modulus less than 60KPa (the storage modulus of the first adhesive layer 22 and the storage modulus of the second adhesive layer 23 are less than 60KPa). From the figure, it may be seen that the strain value of the first adhesive layer 22 of the flexible display panel 10 using the spacer layer 2 in the present embodiment is approximately 0.23, the strain value of the second adhesive layer 23 of the flexible display panel 10 using the spacer layer 2 in the present embodiment is approximately 0.21; whereas the strain values of the first adhesive layer 22 and the second adhesive layer 23 of the display panel 10 using the spacer layer 2 with the storage modulus less than 60KPa is approximately 0.47 and 0.47, respectively; the strain value of the first adhesive layer 22 of the display panel 10 using the spacer layer 2 with the storage modulus less than 60KPa is increased by approximately 104% compared to the strain value of the first adhesive layer 22 of the display panel 10 using the spacer layer 2 in the present exemplary embodiment, and the strain value of the second adhesive layer 23 of the flexible display panel 10 using the spacer layer 2 with the storage modulus less than 60KPa is increased by approximately 124% compared to the strain value of the second adhesive layer 23 of the flexible display panel 10 using the spacer layer 2 in the present exemplary embodiment.

Thus, the use of the spacer layer 2 with the relatively low storage modulus increases the risk of failure for the first adhesive layer 22 and the second adhesive layer 23, while the first adhesive layer 22 and the second adhesive layer 23 of the flexible display panel 10 using the spacer layer 2 in the present exemplary embodiment have a relatively low failure risk.

Moreover, in high-temperature environments, the adhesion force between the first adhesive layer 22 with the storage modulus less than 60KPa and the back film 3 and the adhesion force between the second adhesive layer 23 with the storage modulus less than 60KPa and the back film 3 are less than 1000gf/inch, resulting in delamination of the spacer layer 2 in actual tests.

Furthermore, in order to prevent the adhesive overflow during the bonding process, the spacer layer 2 may be retracted by 0.1 to 0.2 mm relative to the back film 3 in the length direction, and that is, the spacer layer 2 is 0.2 to 0.4 mm shorter than the back film 3 in the length direction. The spacer layer 2 may be retracted by 0.1 mm to 0.2 mm relative to the back film 3 in the width direction, ant that is, the spacer layer 2 is 0.2 mm to 0.4 mm shorter than the back film 3 in the width direction.

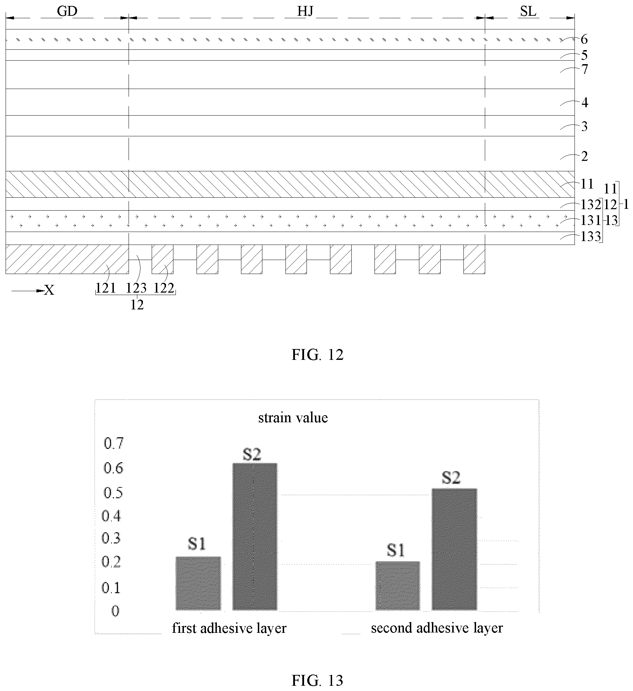

In addition, in some other exemplary embodiments of the present disclosure, as shown in FIG. 12, a material of the spacer layer 2 may be an OCA optical adhesive, and a thickness of the spacer layer 2 may be greater than or equal to 25 microns and less than or equal to 50 microns. For example, the thickness of the spacer layer 2 may be 26 microns, 31 microns, 36.5 microns, 39 microns, 41.3 microns, 44.5 microns, 45.7 microns, 46.3 microns, 47.5 microns, 48.7 microns, etc.; the storage modulus of the spacer layer 2 is less than or equal to 40 Kpa, and the adhesion force of the spacer layer 2 is greater than or equal to 1000gf/inch. The test indicates that the spacer layer 2 of the OCA optical adhesive may also achieve the same effect as the spacer layer 2 of the foam and pressure sensitive adhesive material mentioned above.

Specific structure of the support member 1 will be illustrated in detail below.

As shown in FIGS. 2 and 4, the support member 1 may include a first support layer 11, a second support layer 12, and a bond layer 13.

The first support layer 11 may include a first support plate 111, a second support plate 112, and a third support plate 113 sequentially connected in the first direction X. A modulus of the first support layer 11 in the tensile direction (i.e. the first direction X) is less than or equal to 4 Mpa, and the thickness of the first support layer 11 is greater than or equal to 100 microns and less than or equal to 200 microns. For example, the thickness of the first support layer 11 may be 106 microns, 119 microns, 121 microns, 136.5 microns, 139 microns, 141.3 microns, 144.5 microns, 155.7 microns, 156.3 microns, 168.5 microns, 169.7 microns, 171.3 microns, 174.5 microns, 185.7 microns, 186.3 microns 198.5 microns, 199.7 microns, etc. This setting may reduce the risk of delamination in the first adhesive layer 22 and the second adhesive layer 23 of the spacer layer 2, as well as a first bonding adhesive layer 132 and a second bonding adhesive layer 133 of the bond layer 13.

As shown in FIG. 13, S1 represents a flexible display panel 10 using a first support layer 11 in the present exemplary embodiment, and S2 represents a flexible display panel 10 using a first support layer 11 with a modulus greater than 10MPa in the tensile direction. From the figure, it may be seen that the strain values of the first adhesive layer 22 and the second adhesive layer 23 of S1, the flexible display panel 10 of the first support layer 11 in the present exemplary embodiment, are approximately 0.23 and 0.21, respectively; whereas the strain values of the first adhesive layer 22 and the second adhesive layer 23 of S2, the flexible display panel 10 using the first support layer 11 with the modulus greater than 10MPa in the tensile direction, are approximately 0.63 and 0.52, respectively. The strain value of the first adhesive layer 22 of S2, the flexible display panel 10 using the first support layer 11 with the modulus greater than 10MPa in the tensile direction is increased by approximately 174% compared to the strain value of the first adhesive layer 22 of S1, the flexible display panel 10 using the first support layer 11 in the present exemplary embodiment, and the strain value of the second adhesive layer 23 of S2, the flexible display panel 10 using the first support layer 11 with the modulus greater than 10MPa in the tensile direction, is increased by approximately 148% compared to the strain value of the second adhesive layer 23 of S1, the flexible display panel 10 using the first support layer 11 in the present exemplary embodiment.

Thus, S2 that uses the first support layer 11 with the modulus greater than 10MPa in the tensile direction increases the risk of failure for the first adhesive layer 22 and the second adhesive layer 23, while S1, the display panel 10 using the first support layer 11 in the present exemplary embodiment, has a relatively low failure risk for the first adhesive layer 22 and the second adhesive layer 23.

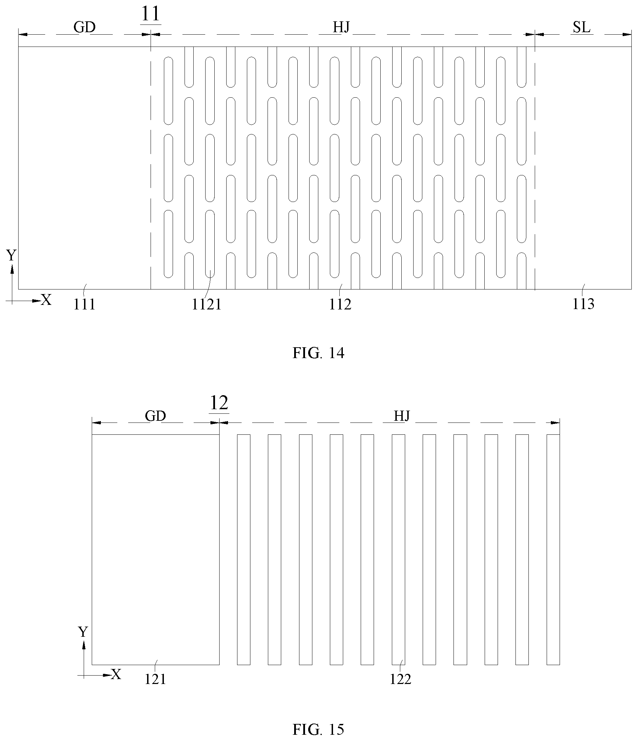

Specifically, as shown in FIG. 14, the first support plate 111 is provided on the fixing region GD, and the first support plate 111 is configured as a whole plate. The second support plate 112 is provided on the scrollable region HJ, and a plurality of via holes 1121 are defined on the second support plate 112, the shape of the via hole 1121 may be circular, elliptical, or various polygons; the shape of the via hole 1121 may also be elongated, and the extension direction of the via hole 1121 is perpendicular to the tensile direction, the extension direction of the via hole 1121 is perpendicular to a scrolling direction of the display panel 10, and that is, the via hole 1121 extends in the second direction Y. Moreover, the via hole 1121 are staggered, such that the moduli across the second support plate 112 in the tensile direction are basically the same. The third support plate 113 is provided on the force application region SL, and the third support plate 113 is configured as a whole plate.

As shown in FIG. 15, the second support layer 12 is provided on the side of the first support layer 11 away from the cover plate 6; the second support layer 12 may include a fourth support plate 121, a plurality of first support strips 122, and a plurality of connection portions 123. The fourth support plate 121 is provided on the fixing region GD, the fourth support plate 121 is configured as a whole plate structure, the fourth support plate 121 covers the entire fixing region GD, and the thickness of the fourth support plate 121 is greater than or equal to 200 microns and less than or equal to 500 microns. For example, the thickness of the fourth support plate 121 may be 206 microns, 219 microns, 231 microns, 256.5 microns, 289 microns, 321.3 microns, 344.5 microns, 355.7 microns, 386.3 microns, 398.5 microns, 419 microns 425 microns, 436 microns, 448 microns, 467 microns, 471 microns, 486 microns, etc.

The plurality of first support strips 122 are provided on the scrollable region HJ, and a first gap is defined between the first support strip 122 and the fourth support plate 121, a second gap is defined between two adjacent first support strips 122, and a thickness of the first support strip 122 is greater than or equal to 200 microns and less than or equal to 500 microns. The first support strip 122 extends along the second direction Y, where the second direction Y intersects with the first direction X, for example, the second direction Y is perpendicular to the first direction X. A width of the first support strip 122 in the first direction X is greater than or equal to 0.5 mm and less than or equal to 1 mm. The width of the second gap between two adjacent first support strips 122 in the first direction X is greater than or equal to 0.4 mm and less than or equal to 1 mm.

A material of the connection portion 123 may be a flexible material, such as silicone, TPU (Thermoplastic Polyurethanes), etc. In this case, the plurality of connection portions 123 are provided in the first gap and the second gap in a one-to-one correspondence, and that is, one connection portion 123 is provided in one first gap, and one connection portion 123 is provided in one second gap. A modulus of the connection portion is greater than or equal to 1 MPa and less than or equal to 6 Mpa. A length of the connection portion 123 in the first direction X may be less than or equal to a length of the first support strip 122 in the first direction X.

The connection portion 123 may also be a connection rib connected between two adjacent first support strips 122 and between the first support strip 122 and the fourth support plate 121. In this case, a material of the connection portion 123 may be the same as that of the first support strip 122, the length of the connection portion 123 in the first direction X is much less than that of the first support strip 122 in the first direction X, at least two connection portions 123 are provided in one first gap, and at least two connection portions 123 are provided within one second gap.

The connection portion 123 may ensure the stability of the width of the second gap between the first support strips 122, and prevent the collision of the adjacent first support strips 122 during the scrolling process.

The bond layer 13 is bonded between the first support layer 11 and the second support layer 12. The bond layer 13 may include a base layer 131, a first bonding adhesive layer 132, and a second bonding adhesive layer 133. A thickness of the base layer 131 is greater than or equal to 20 microns and less than or equal to 30 microns, for example, the thickness of the base layer 131 may be 26 microns, 29 microns, 31 microns, 36.5 microns, 39 microns, etc.; a material of the base layer 131 is TPU (Thermoplastic Polyurethanes); the first bonding adhesive layer 132 is provided on a side of the base layer 131 close to the first support layer 11; and the second bonding adhesive layer 133 is provided on a side of the base layer 131 close to the second support layer 12.

Furthermore, in order to prevent the adhesive overflow during the bonding process, the bond layer 13 may be retracted by 0.1 mm to 0.2 mm in the length direction relative to the first support layer 11 and the second support layer 12, and that is, the bond layer 13 is 0.2 mm to 0.4 mm shorter than the first support layer 11 and the second support layer 12 in the length direction. The bond layer 13 may be retracted by 0.1 mm to 0.2 mm relative to the first support layer 11 and the second support layer 12 in the width direction, and that is, the bond layer 13 is 0.2 mm to 0.4 mm shorter than the first support layer 11 and the second support layer 12 in the width direction.

The thickness of the first bonding adhesive layer 132 is greater than or equal to 15 microns and less than or equal to 30 microns. For example, a thickness of the first bonding adhesive layer 132 may be 16 microns, 19 microns, 21 microns, 26.5 microns, 29 microns, etc; a storage modulus of the first bonding adhesive layer 132 is greater than 100 KPa, and an adhesion force of the first bonding adhesive layer 132 is greater than or equal to 1000 gf/inch. A thickness of the second bonding adhesive layer 133 is greater than or equal to 15 microns and less than or equal to 30 microns. For example, the thickness of the second bonding adhesive layer 133 may be 16 microns, 19 microns, 21 microns, 26.5 microns, 29 microns, etc; a storage modulus of the first bonding adhesive layer 132 is greater than 100 KPa, and an adhesion force of the second bonding adhesive layer 133 is greater than or equal to 1000 gf/inch. According to simulation and test results, this design may reduce the risk of delamination defects that is prone to occur in the first bonding adhesive layer 132 and the second bonding adhesive layer 133.

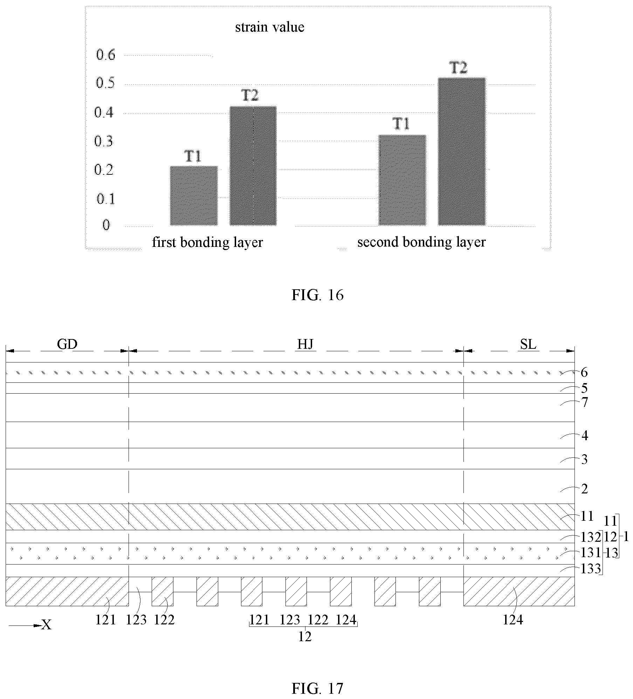

Specifically, as shown in FIG. 16, T1 represents a flexible display panel 10 using the first bonding adhesive layer 132 and the second bonding adhesive layer 133 in the present exemplary embodiment, and T2 represents a flexible display panel 10 using the first bonding adhesive layer 132 and the second bonding adhesive layer 133 with storage moduli lower than 60 KPa. From the figure, it may be seen that the stress value of the first bonding adhesive layer 132 of T1, the flexible display panel 10 using the first bonding adhesive layer 132 and the second bonding adhesive layer 133 in the present exemplary embodiment, is approximately 0.21, the stress value of the second bonding adhesive layer 133 of T1 is approximately 0.32, whereas the stress value of the first bonding adhesive layer 132 of T2, the flexible display panel 10 using the first bonding adhesive layer 132 and the second bonding adhesive layer 133 with the storage moduli lower than 60 KPa, is approximately 0.42, and the stress value of the second bonding adhesive layer 133 of T2 is approximately 0.52. The stress value of the first bonding adhesive layer 132 of T2, the display panel 10 using the first bonding adhesive layer 132 and the second bonding adhesive layer 133 with the storage moduli lower than 60 KPa is increased by approximately 100% compared to the stress value of the first bonding adhesive layer 132 of T1, the display panel 10 using the first bonding adhesive layer 132 and the second bonding adhesive layer 133 in the present exemplary embodiment, the stress value of the second bonding adhesive layer 133 of T2, the display panel 10 using the first bonding adhesive layer 132 and the second bonding adhesive layer 133 with storage moduli lower than 60 KPa is increased by approximately 62.5% compared to the stress value of the second bonding adhesive layer 133 of T1, the display panel 10 using the first bonding adhesive layer 132 and the second bonding adhesive layer 133 in the present exemplary embodiment.

Thus, the use of the first bonding adhesive layer 132 and the second bonding adhesive layer 133 with storage moduli lower than 60KPa in T2 raises the risk of failure for the first bonding adhesive layer 132 and the second bonding adhesive layer 133, while, in T1, the display panel 10 using the first bonding adhesive layer 132 and the second bonding adhesive layer 133 in the present exemplary embodiment has a relatively low failure risk for the first bonding adhesive layer 132 and the second bonding adhesive layer 133.

As shown in FIG. 12, the primary difference between the present exemplary embodiment in FIG. 2 and the present exemplary embodiment in FIG. 4 is that the spacer layer 2 is set as one layer, and the material of the spacer layer 2 may be the OCA optical adhesive. The specific requirements of this material for the spacer layer 2 is previously detailed above, which will not be elaborated here. Moreover, the structures of the first support layers 11 are different, while the other film layers have the same structure.

Specifically, the first support layer 11 covers the entire spacer layer 2, the first support layer 11 is provided on the fixing region GD, the scrollable region HJ, and the force application region SL, that is, the first support layer 11 is set as a whole layer without etching patterns such as via holes set on the first support layer 11. The thickness of the first support layer 11 is greater than or equal to 20 microns and less than or equal to 40 microns, for example, the thickness of the first support layer 11 may be 21 microns, 25 microns, 26.5 microns, 29 microns, 31 microns, 36.5 microns, 39 microns, etc.; the Young's modulus of the first support layer 11 is greater than or equal to 90 GPa and less than or equal to 200Gpa. For example, the Young's modulus of the first support layer 11 may be 93.3Gpa, 95.8Gpa, 98Gpa, 104.2Gpa, 114Gpa, 128Gpa, 148Gpa, 152Gpa, 167Gpa, 184Gpa, 187Gpa, 194Gpa, etc.

According to the simulation results, using the first support layer 11, compared to using the first support layer 11 in FIGS. 2 and 4, there is no risk of delamination of the first bonding adhesive layer 132 and the second bonding adhesive layer 133 due to the use of the OCA optical adhesive instead of the bond layer 13 including the base layer 131, the first bonding adhesive layer 132, and the second bonding adhesive layer 133. Moreover, the modulus of the OCA optical adhesive is relatively low, which may better absorb the film layer displacement caused by the first support layer 11 of this structure.

In addition, it should be noted that due to the high fluidity of the OCA optical adhesive, the spacer layer 2 of the OCA optical adhesive is generally used in conjunction with the first support layer 11 set as the whole layer.

As shown in FIG. 17, the primary difference between the present exemplary embodiment in FIG. 17 and the present exemplary embodiment in FIG. 12 is that the second support layer 12 may also include a fifth support plate 124, while the structures of other film layers are the same.

Specifically, the fifth support plate 124 is arranged on the force application region SL, and the thickness of the fifth support plate 124 is greater than or equal to 200 microns and less than or equal to 500 microns. For example, the thickness of the fifth support plate 124 may be 221 microns, 285 microns, 365 microns, 389 microns, 431 microns, 465 microns, 493 microns, etc. The fifth support plate 124 is bonded to the first support layer 11 through a bond layer 13. The arrangement of the fifth support plate 124 may further increase the strength of the force application region SL, ensuring that applying the tension to the force application region SL does not cause damage to the force application region SL. A gap is also defined between the fifth support plate 124 and the first support strip 122, and a connection portion 123 is also provided within the gap.

In addition, it should be noted that in the example embodiments shown in FIGS. 2, 4, and 12, a fifth support plate 124 may also be provided. Through the fifth support plate 124, the strength of the force application region SL may be further increased, ensuring that in the case that the tension is applied to the force application region SL, damage to the force application region SL does not occur.

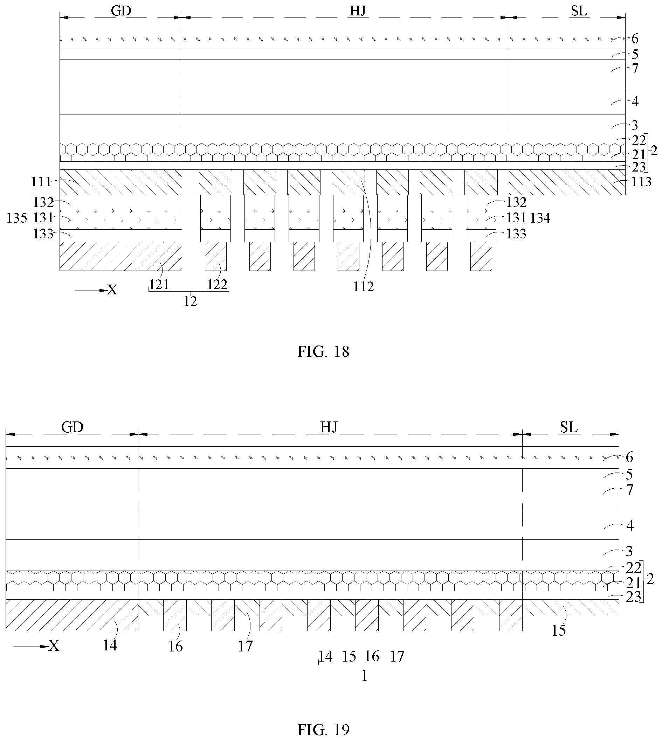

As shown in FIG. 18, the primary difference between the present exemplary embodiment in FIG. 18 and the present exemplary embodiment in FIG. 2 is that the structures of the second support layers 12 and the bond layers 13 are different, while the other film layers have the same structure.

Specifically, the bond layer 13 may include a bonding portion 134 and a plurality of bonding strips 135; the bonding portion 134 is bonded between the fourth support plate 121 and the first support layer 11, that is, the bonding portion 134 is only set on the fixing region GD; each bonding strip 135 is bonded between the first support strip 122 and the first support layer 11, and that is, the first support strip 122 is correspondingly bonded to the first support layer 11 through the bonding strip 135. The bonding strip 135 extends in the second direction Y, and a gap is defined between two adjacent bonding strips 135, and a gap is also defined between the bonding strip 135 closest to the bonding portion 134 and the bonding portion 134. A width of the bonding strip 135 in the first direction X is greater than or equal to a width of the first support strip 122 in the first direction X, and an orthographic projection of the first support layer 11 on the back film 3 is located within an orthographic projection of the bonding strip 135 on the back film 3. For example, in the case where the width of the bonding strip 135 in the first direction X is equal to the width of the first support strip 122 in the first direction X, the orthographic projection of the first support layer 11 on the back film 3 is completely coincident with the orthographic projection of the bonding strip 135 on the back film 3; in the case where the width of the bonding strip 135 in the first direction X is greater than the width of the first support strip 122 in the first direction X, the orthographic projection of the bonding strip 135 on the back film 3 covers and is greater than the orthographic projection of the first support layer 11 on the back film 3; so as to ensure the bonding effect between the first support strip 122 and the first support layer 11.

In this case, the first support strip 122 may be designed with a greater width and smaller spacing to improve the support capability of the support member 1. For example, the width of the first support strip 122 in the first direction X is greater than or equal to 1.0 mm and less than or equal to 1.5 mm. The width of the gap between two adjacent first support strips 122 in the first direction X is less than or equal to 0.5 mm.

In addition, in the case where a via hole 1121 is defined on the second support plate 112 of the first support layer 11, the orthographic projection of the bonding strip 135 on the back film 3 does not overlap with the orthographic projection of the via hole 1121 on the back film 3, ensuring that the bonding strip 135 is fully bonded to the first support layer 11, that is, ensuring that there is no blank space left for the bonding strip 135 and there is no part that is not bonded to the first support layer 11, to ensure the bonding effect between the first support strip 122 and the first support layer 11.

Such arrangement may reduce the amount of bond layer 13 and reduce the weight of the entire display panel.

It should also be noted that in the example embodiments shown in FIGS. 4, 12, and 17, the second support layer 12 and the bond layer 13 shown in FIG. 18 may also be provided.

As shown in FIG. 19, the primary difference between the present exemplary embodiment in FIG. 19 and the present exemplary embodiment in FIG. 2 is that the structures of support members 1 are different, while other film layers have the same structure.

Specifically, the support member 1 may include a sixth support plate 14, a seventh support plate 15, a plurality of second support strips 16, and a plurality of eighth support plates 17. The sixth support plate 14 is provided on the fixing region GD, and the sixth support plate 14 is configured as a whole plate structure, that is, no via hole is defined on the sixth support plate 14. A thickness of the sixth support plate 14 may be greater than or equal to 200 microns and less than or equal to 500 microns. For example, the thickness of the sixth support plate 14 may be 221 microns, 285 microns, 365 microns, 389 microns, 431 microns, 465 microns, 493 microns, etc.

The seventh support plate 15 is provided on the force application region SL, and the seventh support plate 15 is configured as a whole plate structure, that is, no through hole is defined on the seventh support plate 15. A thickness of the seventh support plate 15 is greater than or equal to 100 microns and less than or equal to 200 microns. For example, the thickness of the seventh support plate 15 may be 121 microns, 135 microns, 146 microns, 159 microns, 161 microns, 174 microns, 189 microns, 195 microns, etc.

The plurality of second support strips 16 are provided between the sixth support plate 14 and the seventh support plate 15, that is, the plurality of second support strips 16 are provided on the scrollable region HJ, the second support strip 16 extends in the second direction Y, and the thickness of the second support strip 16 is greater than or equal to 200 microns and less than or equal to 500 microns. For example, the thickness of the second support strip 16 may be 221 microns, 285 microns, 365 microns, 389 microns, 431 microns, 465 microns, 493 microns, etc. A gap is defined between two adjacent second support strips 16, a gap is also defined between the second support strip 16 and the sixth support plate 14, and a gap is also defined between the second support strip 16 and the seventh support plate 15. The eighth support plate 17 is provided in the interval between the two adjacent second support strips 16, the eighth support plate 17 is also provided in the interval between the second support strip 16 and the sixth support plate 14, the eighth support plate 17 is also provided in the interval between the second support strip 16 and the seventh support plate 15, and at least one through hole is defined on the eighth support plate 17.

It should also be noted that in the example embodiments shown in FIGS. 4, 12, and 17, the structure of the support member 1 shown in FIG. 19 may also be adopted.

It should be noted that in addition to the flexible display panel 10, the scrollable display apparatus also includes other necessary components and components, such as a housing, a circuit board, a power cable, etc. Additional components may be added as needed by those skilled in the field based on the specific usage requirements of the display apparatus, which will not be further elaborated here.

Other embodiments of the present disclosure will be apparent to those skilled in the art after those skilled in the art consider the specification and practice the technical solutions disclosed herein. The present disclosure is intended to cover any variations, uses, or adaptations of the present disclosure, which are in accordance with the general principles of the present disclosure and include common general knowledge or conventional technical means in the art that are not disclosed in the present disclosure. The specification and embodiments are illustrative, and the real scope and spirit of the present disclosure is defined by the appended claims.

## Claims

1. A scrollable display apparatus, comprising a flexible display panel, wherein the flexible display panel comprises a fixing region, a scrollable region, and a force application region sequentially connected along a first direction, wherein the flexible display panel comprises:
a support member;
a spacer layer, provided on a side of the support member;
a back film, provided on a side of the spacer layer away from the support member;
a display base substrate, provided on a side of the back film away from the support member;
a first bonding layer, provided on a side of the display base substrate away from the support member; and
a cover plate, provided on a side of the first bonding layer away from the support member, wherein a thickness of the cover plate is greater than or equal to 60 microns and less than or equal to 240 microns, and a tensile modulus of the cover plate is greater than or equal to 3GPa and less than or equal to 7GPa.

2. The scrollable display apparatus according to claim 1, wherein the cover plate is configured as a single-layer structure, the thickness of the cover plate is greater than or equal to 70 microns and less than or equal to 90 microns, and a hardness of a surface of the cover plate away from the support member is greater than a hardness of a surface of the cover plate close to the support member.

3. The scrollable display apparatus according to claim 1, wherein the cover plate is configured as a multi-layer structure.

4. The scrollable display apparatus according to claim 3, wherein the cover plate comprises:
a first layer, provided on the side of the first bonding layer away from the support member, wherein a thickness of the first layer is greater than or equal to 50 microns and less than or equal to 90 microns;
a second bonding layer, provided on a side of the first layer away from the support member, wherein a thickness of the second bonding layer is greater than 25 microns and less than or equal to 50 microns, and a storage modulus of the second bonding layer is greater than or equal to 20KPa and less than or equal to 60Kpa; and
a second layer, provided on a side of the second bonding layer away from the support member, wherein a thickness of the second layer is greater than or equal to 50 microns and less than or equal to 90 microns, a hardness of a surface of the second layer away from the support member is greater than a hardness of a surface of the second layer close to the support member.

5. The scrollable display apparatus according to claim 4, wherein a material of the first layer is polyimide, and a Young's modulus of the first layer is greater than or equal to 6GPa and less than or equal to 7Gpa; a material of the second layer is polyimide, and a Young's modulus of the second layer is greater than or equal to 6GPa and less than or equal to 7Gpa; or
a material of the first layer is polyethylene terephthalate, and a Young's modulus of the first layer is greater than or equal to 4GPa and less than or equal to 6Gpa; a material of the second layer is polyethylene terephthalate, and a Young's modulus of the second layer is greater than or equal to 4GPa and less than or equal to 6Gpa.

6. The scrollable display apparatus according to claim 4, wherein a storage modulus of the first bonding layer is greater than or equal to the storage modulus of the second bonding layer, and a thickness of the first bonding layer is less than or equal to the thickness of the second bonding layer.

7. The scrollable display apparatus according to any one of claims 1-6, wherein a material of the first bonding layer is an OCA optical adhesive, a thickness of the first bonding layer is greater than or equal to 25 microns and less than or equal to 50 microns, and a storage modulus of the first bonding layer is greater than or equal to 50KPa and less than or equal to 70KPa.

8. The scrollable display apparatus according to claim 7, wherein the flexible display panel further comprises:
a polarizer, provided between the display base substrate and the first bonding layer, wherein a thickness of the polarizer is greater than or equal to 60 microns and less than or equal to 70 microns, and a modulus of the polarizer is greater than or equal to 4 GPa and less than or equal to 5Gpa.

9. The scrollable display apparatus according to claim 8, wherein a thickness of the back film is greater than or equal to 40 microns and less than or equal to 70 microns, and a Young's modulus of the back film is greater than or equal to 3GPa and less than or equal to 4Gpa.

10. The scrollable display apparatus according to claim 9, wherein the spacer layer comprises:
a substrate, wherein a material of the substrate is foam, and a thickness of the substrate is greater than or equal to 50 microns and less than or equal to 100 microns;
a first adhesive layer, bonded between the substrate and the back film, wherein an adhesion force of the first adhesive layer is greater than or equal to 1000 gf/inch, a storage modulus of the first adhesive layer is greater than or equal to 100 Kpa, and a thickness of the first adhesive layer is greater than or equal to 20 microns and less than or equal to 30 microns; and
a second adhesive layer, bonded between the substrate and the support member, wherein an adhesion force of the second adhesive layer is greater than or equal to 1000 gf/inch, a storage modulus of the second adhesive layer is greater than or equal to 100 Kpa, and a thickness of the second adhesive layer is greater than or equal to 20 microns and less than or equal to 30 microns.

11. The scrollable display apparatus according to claim 9, wherein a material of the spacer layer is an OCA optical adhesive, a thickness of the spacer layer is greater than or equal to 25 microns and less than or equal to 50 microns, a storage modulus of the spacer layer is less than or equal to 40Kpa, and an adhesion force of the spacer layer is greater than or equal to 1000gf/inch.

12. The scrollable display apparatus according to any one of claims 1-6, wherein the display base substrate comprises:
a display layer group, provided on the side of the back film away from the support member;
an encapsulation layer group, provided on a side of the display layer group away from the support member;
a touch layer group, provided on a side of the encapsulation layer group away from the support member; and
a polarization layer group, provided on a side of the touch layer group away from the support member, wherein a storage modulus of the first bonding layer is greater than or equal to 50KPa and less than or equal to 130KPa.

13. The scrollable display apparatus according to claim 1, wherein the support member comprises:
a first support layer covering the entire spacer layer, wherein a thickness of the first support layer is greater than or equal to 20 microns and less than or equal to 40 microns, and a Young's modulus of the first support layer is greater than or equal to 90 GPa and less than or equal to 200 Gpa;
a second support layer, provided on a side of the first support layer away from the cover plate; and
a bond layer, bonded between the first support layer and the second support layer.

14. The scrollable display apparatus according to claim 1, wherein the support member comprises:
a first support layer comprising a first support plate, a second support plate, and a third support plate sequentially connected, wherein the first support plate is provided on the fixing region, the second support plate is provided on the scrollable region, the third support plate is provided on the force application region, a plurality of via holes are defined on the second support plate, a modulus of the first support layer in a tensile direction is less than or equal to 4Mpa, a thickness of the first support layer is greater than or equal to 100 microns and less than or equal to 200 microns, and the tensile direction is consistent with the first direction;
a second support layer, provided on a side of the first support layer away from the cover plate; and
a bond layer, bonded between the first support layer and the second support layer.

15. The scrollable display apparatus according to claim 13 or 14, wherein the bond layer comprises:
a base layer, wherein a thickness of the base layer is greater than or equal to 20 microns and less than or equal to 30 microns;
a first bonding adhesive layer, bonded between the base layer and the first support layer;
a second bonding adhesive layer, bonded between the base layer and the second support layer;
wherein a thickness of the first bonding adhesive layer is greater than or equal to 15 microns and less than or equal to 30 microns, a storage modulus of the first bonding adhesive layer is greater than 100 KPa, and an adhesion force of the first bonding adhesive layer is greater than or equal to 1000 gf/inch; a thickness of the second bonding adhesive layer is greater than or equal to 15 microns and less than or equal to 30 microns, a storage modulus of the first bonding adhesive layer is greater than 100 KPa, and an adhesion force of the second bonding adhesive layer is greater than or equal to 1000 gf/inch.

16. The scrollable display apparatus according to claim 13 or 14, wherein the second support layer comprises:
a fourth support plate, provided on the fixing region, wherein a thickness of the fourth support plate is greater than or equal to 200 microns and less than or equal to 500 microns;
a plurality of first support strips, provided on the scrollable region, wherein a first gap is defined between a first support strip adjacent to the fourth support plate and the fourth support plate, a second gap is defined between two adjacent first support strips, a thickness of the first support strip is greater than or equal to 200 microns and less than or equal to 500 microns, and the first support strip extends along a second direction intersecting with the first direction; and
a connection portion, provided in the first and second gaps, wherein a modulus of the connection portion is greater than or equal to 1 MPa and less than or equal to 6 MPa.

17. The scrollable display apparatus according to claim 16, wherein the second support layer further comprises:
a fifth support plate, provided on the force application region, wherein a thickness of the fifth support plate is greater than or equal to 200 microns and less than or equal to 500 microns.

18. The scrollable display apparatus according to claim 16, wherein the bond layer comprises:
a bonding portion, bonded between the fourth support plate and the first support layer; and
a plurality of bonding strips, wherein each bonding strip is correspondingly bonded between the first support strip and the first support layer, an orthographic projection of the first support strip on the back film is located within an orthographic projection of the bonding strip on the back film.

19. The scrollable display apparatus according to claim 18, wherein the first support layer is the first support layer according to claim 14, and the orthographic projection of the bonding strip on the back film does not overlap with an orthographic projection of the via hole on the back film.

20. The scrollable display apparatus according to claim 1, wherein the support member comprises:
a sixth support plate, provided on the fixing region, wherein a thickness of the sixth support plate is greater than or equal to 200 microns and less than or equal to 500 microns;
a seventh support plate, provided on the force application region, wherein a thickness of the seventh support plate is greater than or equal to 100 microns and less than or equal to 200 microns;
a plurality of second support strips, provided between the sixth support plate and the seventh support plate, wherein a thickness of the second support strip is greater than or equal to 200 microns and less than or equal to 500 microns, and the second support strip extends along a second direction intersecting with the first direction; and
a plurality of eighth support plates, provided between two adjacent second support strips, between the second support strip and the sixth support plate, and between the second support strip and the seventh support plate, wherein the eighth support plate is defined with at least one via hole, and a thickness of the eighth support plate is greater than or equal to 100 microns and less than or equal to 200 microns.
